# EUROPEAN PATENT APPLICATION

(11) **EP 1 857 879 A1**
(43) Date of publication of application: **21.11.2007**
(21) Application number: 06113941.6
(22) Date of filing: 15.05.2006
(51) Int. Cl.: G03F 7/20, G02B 5/30

(54) **An illumination system and a photolithography apparatus**

(71) Applicant: Advanced Mask Technology Center GmbH & Co. KG, 01109 Dresden (DE)
(72) Inventor: Bubke, Karsten, 01129 Dresden (DE); Sczyrba, Martin, Dr., 01159 Dresden (DE)
(74) Representative: Kottmann, Heinz Dieter

(57) **Abstract**

The present invention refers to an illumination system as well as to a photolithography apparatus employing the illumination system.

The illumination system comprises a device for generating an illumination distribution, the illumination distribution (6) having a center point (32) and an outer edge (33), the illumination distribution (6) comprising a first opaque portion (34) which is defined about the center point (32), a second opaque portion (35) which is defined adjacent to the outer edge (33), and a radiation transmittant portion (36) which is disposed between the first and the second opaque portions (34, 35). The illumination system further comprises a polarization device (23). The polarization device (23) generates a linearly polarized electromagnetic radiation having a locally varying polarization direction (311a,b,c,d), so that at least a first and a second-polarization directions (311a,b) are generated, the first polarization direction (311a) being different from the second polarization direction (311b) and the polarization direction at at least two different points of the radiation transmittant portion of the illumination distribution is parallel to a line connecting this point and the center point (32) of the illumination distribution.

## Description

The present invention relates to an illumination system which is suitable for use in a photolithography apparatus as well as to a photolithography apparatus comprising such an illumination system.

During the manufacture of a semiconductor device, components of the device usually are formed by patterning layers that are deposited on a silicon wafer. The patterning of these layers usually is accomplished by applying a resist material onto the layer which has to be patterned, and by subsequently exposing predetermined portions of the resist layer which is sensitive to the exposure wavelength. Thereafter, the regions which have been irradiated with the radiation (or not) are developed and the irradiated or not irradiated portions are subsequently removed. As a consequence, portions of the layer are masked by the generated photoresist pattern during a following process step, such as an etching step or an implantation step. After processing the exposed portions of the underlying layer, the resist mask is removed.

A general task of present photolithography is to reach smaller pattern sizes as well as a greater admissible depth of focus (DOF) with constant exposure wavelength. This task can be reached with the use of novel masks, in particular phase shifting masks, and, alternatively, with the use of off-axis illumination.

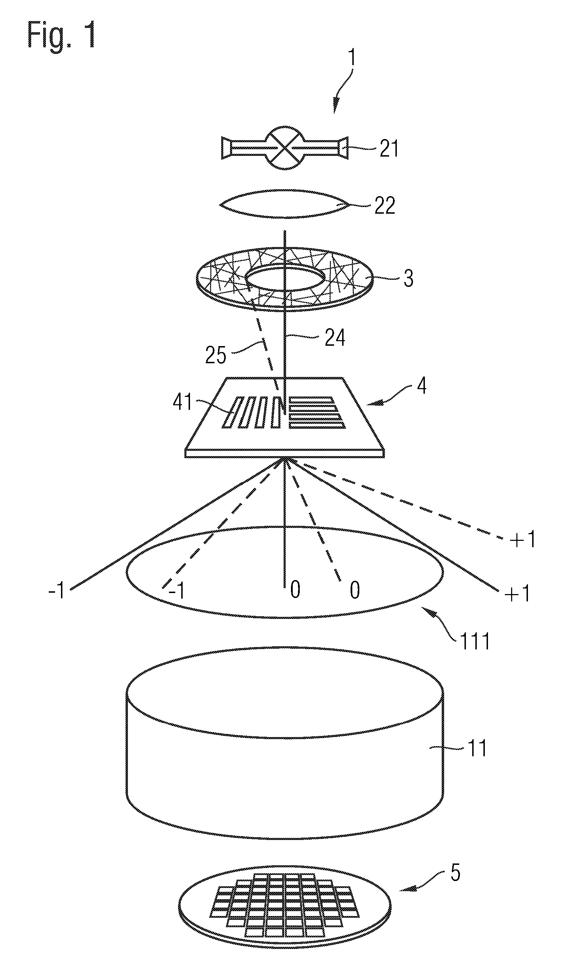

The effect of off-axis illumination can, for example, be recognized from Fig. 1. Fig. 1 shows a schematic view of an optical projection or photolithography apparatus 1 for imaging a pattern formed on a reticle 4 onto a substrate, in particular a semiconductor wafer to be patterned. An illumination source 21 emits electromagnetic radiation in a predetermined wavelength range. The optical projection apparatus further includes a condensor lens 22, a device for generating an illumination distribution 3 as well as the reticle 4. A pattern 41 is formed on the reticle 4. The pattern 41 of the reticle 4 is imaged by the projection system 11 onto the wafer 5. The device for generating an illumination distribution 3 can be formed so as to define an arbitrary illumination distribution in the illumination pupil plane of the optical projection apparatus 1. The device for generating an illumination distribution 3 can, for example, be an aperture element 3, as is indicated in Fig. 1. In the example, the aperture element 3 can be formed so as to provide an axial light beam 24 which impinges perpendicularly onto the reticle 4. In this case, the aperture element for example has an opening in the center portion thereof and transmitting 100 % of the incoming radiation. Alternatively, the aperture element 3 can as well have openings which are located outside the center thereof, so that off-axis beams 25 are generated. When the on-axis beam 24 is diffracted by the pattern 41 on the reticle 4, depending on the structural feature sizes, only the 0-th order diffraction beam is located within the entrance pupil region 111 of the projection system 11. However, if the off-axis beam 25 is diffracted by the pattern 41 of the reticle, the 0-th and -1^{st} diffraction order are located within the entrance pupil 111 of the projection system 11. The diffraction orders of the off-axis beam 25 are denoted by broken lines, whereas the diffraction orders of the on-axis beam 24 are indicated by full lines. Generally, the quality of the imaged pattern is the better, the more diffraction orders are located within the entrance pupil region 111 of the lens assembly 11. Accordingly, as becomes clear from Fig. 1, using off-axis illumination, at least two interfering diffraction orders can be generated.

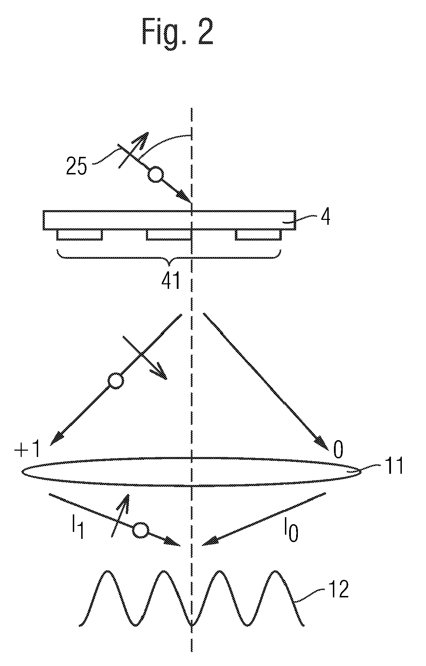

Fig. 2 shows as an example an interference pattern 12 which is formed by superposing the 0^{th} diffraction order and the +1^{st} diffraction order of the diffracted off-axis beam 25. The off-axis lumination can be used, for example, with chrome on glass (COG), halftone phase shifting masks (HTPSM) or chrome phase lithography (CPL) masks.

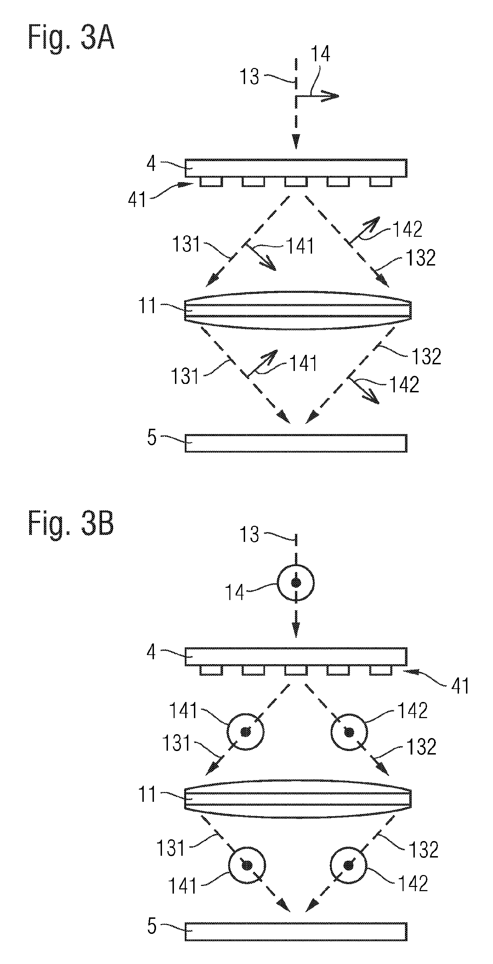

In order to further increase the contrast of printed vs. non-printed lines in a regular lines/spaces pattern, the influence of the polarization direction of the light has been investigated. In particular, as is shown in Fig. 3A, if the incident light has a polarization direction which is perpendicular with respect to the orientation of the mask pattern 41, a loss of image contrast and, hence, a loss of quality of the image projected onto the wafer 5 is caused. In particular, as can be gathered from Fig. 3A, the electrical fields 141 and 142 associated with the first and second diffraction light beams 131, 132 interfere with each other, and, thus, degrade the image on the wafer 5.

In contrast, if the polarization direction 14 of the incident light beam 13 is parallel with respect to the orientation of the pattern 41 of the reticle 4, the associated electrical field is parallel to the direction of propagation of the light 131, 132 and thus, the electrical fields 141, 142 associated with the diffracted light beams 131, 132 are parallel to each other, whereby the contrast of the image is increased. As is shown in Fig. 3B, the polarization direction 141, 142 of the light beams 131, 132 is perpendicular with respect to the plane of the drawing. In particular, they are coming out of the page thought the viewer.

The above problems have been solved, by implementing an illumination distribution using polarized light as is, for example, known from US 6,970,233 B2. To be more specific, as is shown in Fig. 4, a device for generating an illumination distribution generates an illumination distribution 6 in an illumination pupil of the photolithography apparatus. The illumination distribution 6 for implementation off-axis illuminations comprises four poles 30a, b, c, d, wherein the polarization direction in each of the poles is parallel to a circle drawn around a center point (not shown) of the illumination distribution 60. This polarization is referred to azimuthally or tangential polarization, i.e. the electric field is parallel to concentric circuits in the pupil. The shown illumination distribution 60 combined with the special polarization scheme, enables the printing of horizontal and vertical lines with a high contrast.

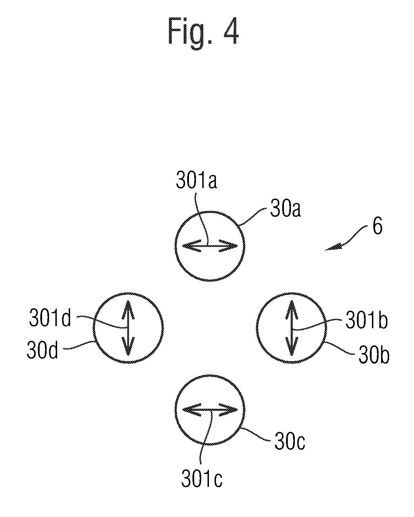

A pole or illumination pole, as is shown in Fig. 4, for example, refers to a portion of the illumination pupil region, the portion having a higher intensity of light than the remaining part of the illumination pupil portion surrounding the illumination pole.

An illumination distribution comprising one or more poles can be generated, for example, by using an appropriate aperture element, a diffractive element or a suitable system of lenses.

In an alternating phase shifting mask (AltPSM) the transparent substrate of the mask itself is patterned so as to provide phase shifting regions. In detail, adjacent transparent regions result in phases shifted by 180°. In addition, optionally, a chrome pattern may be formed on the mask surface. An advantage of alternating phase shifting masks or chromeless phase shifting masks is the low mask error enhancement factor (MEEF). In particular, a low mask error enhancement factor results in defective structures in the masks having only few results on the defects of the image on the wafer. In addition, an increased depth of focus (DOF) and a higher resolution can be obtained with this mask type.

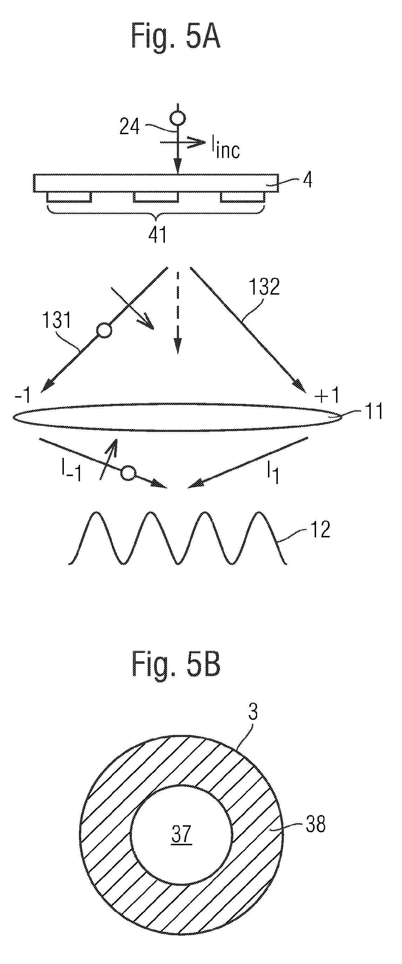

The lithographic working principle of AltPSM masks is fundamentally different from the off-axis schemes explained herein above. As can for example be seen from Fig. 5A, only on-axis illumination is used. As can be seen, the 0-th diffraction order is minimized and the 1^{st} and -1^{st} order are used for imaging dense lines and spaces. In other words, light emitted by a radiation source is diffracted by the pattern 41 on the AltPSM mask 4, so as to generate a +1^{st} and a -1^{st} diffraction order light beam 132, 131. The +1^{st} and -1^{st} diffraction order light beams 132, 131 interfere so as to generate an interference pattern 12. For generating an on-axis beam, an aperture element similar to the one shown in Fig. 5B can be used. As can be seen, the aperture element 3 comprises a transparent portion 37 at a center thereof, while the aperture element has an opaque portion 38 adjacent to the edge portion. In particular, the illumination distribution generated by the aperture element 3 shown in Fig. 5B has a central pole in which the intensity is very high compared to the edges of the illumination distribution. When using AltPSM masks, also the use of polarized light is advantageous. In particular, for transferring a lines/spaces pattern extending in only one direction, it is preferred to use linearly polarized light, wherein the polarization direction is parallel to the orientation of the lines/spaces pattern. As a result, an improved contrast is obtained. However, if a pattern comprising a lines/spaces pattern which is orientated in the x as well as in the y direction is to be transferred, a suitable illumination scheme has not been known up to now.

As can be gathered from Fig. 5B the application of the polarization scheme of Fig. 4 cannot easily be applied to this type of aperture element, since it is composed of only one single pole 36.

In view of the above, it is an object of the present invention to provide an illumination system by which the image contrast and, thus, the image quality of a pattern transferred onto a substrate can be remarkably improved.

Moreover, it is an object of the invention to provide a photolithography apparatus comprising such an illumination system.

According to the present invention, the above objects are achieved by an illumination system, the illumination system being suitable for use in a photolithography apparatus, the illumination system comprising an illumination source emitting electromagnetic radiation, a polarization device, a device for generating an illumination distribution, the illumination distribution generated by the device having a center point and an outer edge, the illumination distribution comprising a first opaque portion which is defined about the center point, each point of the first opaque portion having a distance from the center point smaller than rᵢₙ, a second opaque portion which is defined adjacent to the outer edge, the second opaque portion having a distance from the center point which is larger than rₒᵤₜ, and a radiation transmittant portion which is disposed between the first and the second opaque portions, wherein the polarization device is disposed between the illumination source and the device for generating an illumination distribution, the polarization device being adapted to generate linearly polarized'electromagnetic radiation having a locally varying polarization direction, so that at least a first and a second polarization directions are generated, the first polarization direction being different from the second polarization direction and the polarization direction at at least two different points of the radiation transmittant portion of the illumination distribution is parallel to a line connecting this point and the center point of the illumination distribution.

Preferably, the radiation transmittant portion comprises a first, a second, a third and a fourth pole, wherein the first and the second poles are arranged along a first direction, and the third and fourth poles are arranged along a second direction, the second direction being perpendicular to the first direction, wherein the intensity of transmitted radiation in each of the poles is larger than in another part of the radiation transmittant portion, and wherein the polarization direction of the electromagnetic radiation being transmitted by the first and second poles is parallel to the first direction, and the polarization direction of the electromagnetic radiation being transmitted by the third and fourth poles is parallel to the second direction.

In particular, each of the poles can have a circular shape.

Alternatively, at least one of the poles can have an elliptical shape.

According to a further embodiment of the invention, at least one of the poles can have the shape of a segment of a ring. In particular, the ring may be formed by the contour of the radiation transmittant portion. The segments may be formed so that the borders of the segments, the borders intersecting the contour of the radiation transmittant portion have a radial direction from the center point of the device for generating an illumination distribution.

According to the invention, the diameter of each of the first, second, third and fourth poles can be equal to the difference between rₒᵤₜ and rᵢₙ. Nevertheless, the diameter of each of the first, second, third and fourth poles can be different from each other.

According to a further embodiment of the invention, the radiation transmittant portion has an annular shape, the transmitted intensity of electromagnetic radiation being constant within the radiation transmittant portion.

The present invention further provides a photolithography apparatus comprising a substrate to be patterned, a reticle, the reticle having a plurality of patterns which are to be transferred onto the substrate, the reticle comprising at least one pattern extending in a first direction and having a pattern size dx, an illumination system as defined above and an optical projection system for projecting an image of the reticle onto the substrate, the optical projection system having a Numerical Aperture (NA).

In particular, the radius rₒᵤₜ of the second opaque portion can be determined in dependence from the pattern size dx of the reticle and the Numerical Aperture (NA) of the optical projection system so that for the ± 1^{st} diffraction order part of the light due to illumination with the radiation transmittant portion lies outside the Numerical Aperture of the optical projection system. Accordingly, the parameters of the device for generating an illumination distribution are set in accordance with the lithography apparatus and the pattern to be transferred onto the substrate. To be more specific, the parameters pattern size dx and Numerical Aperture (NA) of the optical projection system are fixed. The parameters of the device for generating an illumination distribution are chosen in correspondence with these parameters, so that for the ± 1^{st} diffraction order part of the light due to illumination with the radiation transmittant portion lies outside the Numerical Aperture of the optical projection system.

In particular, it is preferred that the radius rₒᵤₜ of the second opaque portion is determined in dependence from the pattern size dx of the reticle and the Numerical Aperture (NA) of the optical projection system so that for the + 1^{st} diffraction order the light due to illumination with the first pole lies outside the Numerical Aperture of the optical projection system and for the -1^{st} diffraction order the light due to illumination with the second pole lies outside the Numerical Aperture of the optical projection system.

As a result, it becomes possible to transfer a lines/spaces pattern having an orientation in the x direction as well as a lines/spaces pattern having an orientation in the y direction with a high contrast onto a substrate to be patterned.

In addition, the radius rₒᵤₜ of the second opaque portion can be determined in dependence from the pattern size dx of the reticle and the Numerical Aperture (NA) of the optical projection system so that for the + 1^{st} diffraction order the light due to illumination with the third pole lies outside the Numerical Aperture of the optical projection system and for the -1^{st} diffraction order the light due to illumination with the fourth pole lies outside the Numerical Aperture of the optical projection system.

The photolithography apparatus comprises a reticle which can in particular be an alternating phase shifting mask (AltPSM) or any other photomask wherein the pattern is generated by interference of the ± 1^{st} diffraction orders of the imaging radiation.

The device of generating an illumination distribution comprises an appropriate aperture element, a diffractive element or a suitable system of lenses or a suitable combination of these elements.

In the following, the present invention will be described in greater detail with reference to the accompanying drawings.
- Fig. 1: shows an exemplary view of a photolithography apparatus;
- Fig. 2: shows an example of conventionally imaging with off-axis illumination;
- Fig. 3A: shows an example of imaging with polarized light;
- Fig. 3B: shows another example of imaging with polarized light;
- Fig. 4: shows a conventional illumination distribution;
- Fig. 5A: shows an example of imaging a pattern with an AltPSM mask;
- Fig. 5B: shows an example of a conventional aperture element for implementing on-axis illumination;
- Fig. 6: shows an exemplary view of a photolithography apparatus according to the present invention;
- Fig. 7: illustrates an illumination distribution generated by the illumination system of the present invention;
- Fig. 8A: shows another example of an illumination distribution generated by the illumination system of the present invention;
- Fig. 8B: shows a further example of an illumination distribution generated by the illumination system of the present invention; and
- Fig. 9A: shows another example of an illumination distribution generated by the illumination system of the present invention;
- Fig. 9B: shows a further example of an illumination distribution generated by the illumination system of the present invention;
- Fig. 10: shows exemplary positions of diffracted light beams in the plane of the entrance pupil of the optical projection system;
- Fig. 11: illustrates a further illumination distribution generated by the illumination system of the present invention; and
- Fig. 12: shows further exemplary positions of diffracted light beams in the plane of the entrance pupil of the optical projection system.

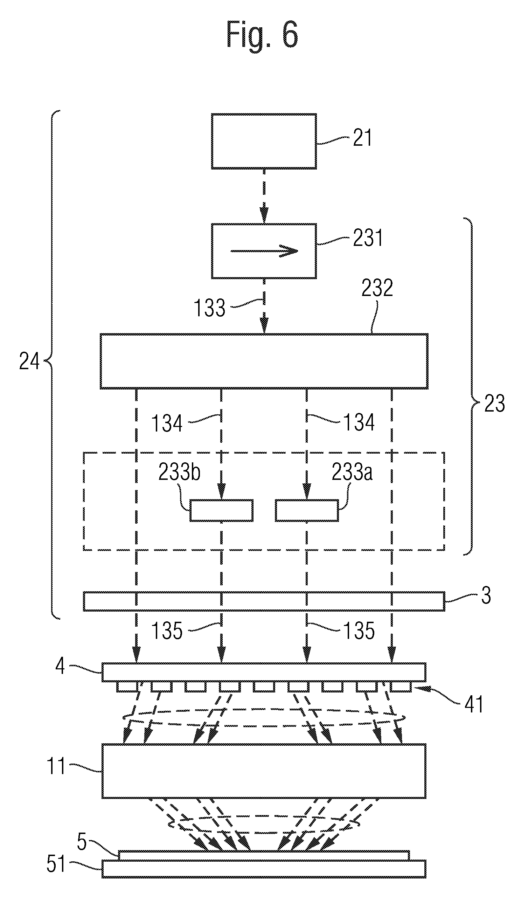

Fig. 6 illustrates an exemplary photolithographic apparatus according to the present invention. The photolithographic apparatus comprises an illumination system 24 which comprises an illumination source 21. The illumination source can be any light source or other device or combination of devices which are capable of generating light used to create a photolithographic image. As used throughout this disclosure, the term "light" refers to electromagnetic radiation in the visible light spectrum as well as the invisible spectrum, including without limitation visible light, ultraviolet light and X-rays. For example, the illumination source 21 may comprise a laser such as an argon fluoride laser, a fluorine excimer laser or a helium neon laser. The illumination system 24 further comprises a polarization device 23 and a device for generating an illumination distribution 3. The polarization device is disposed between the illumination source and the device for generating an illumination distribution 3. The polarization device is adapted to generate linearly polarized electromagnetic radiation having a locally varying polarization direction as will be described hereinafter. In particular, the structure of the polarization device 23 will be described after the description of an illumination distribution generated by the device for generating an illumination distribution 3.

The pattern 41 of the reticle 4 is transferred from the reticle 4 to a wafer 5 by irradiating the reticle with the illumination distribution generated by the illumination system 24. In particular, the pattern 4 is imaged onto the wafer by means of the projection system 11. The reticle 4 usually is held by a stage (not shown). Moreover, the wafer 5 is held by a wafer stage 51.

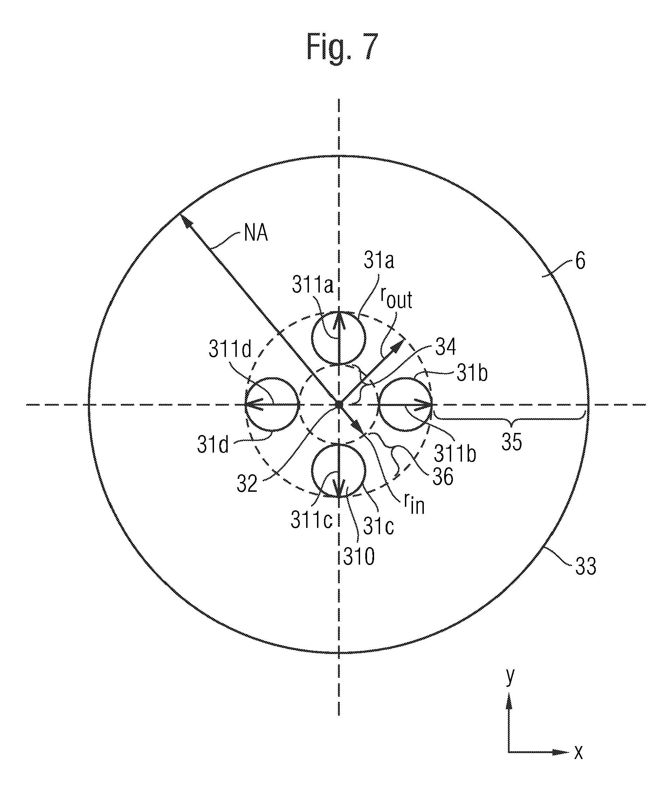

As is shown in Fig. 7 illustrating an illumination distribution generated by the illumination system according to a first embodiment of the present invention, the illumination distribution has a center point at the center thereof. The first opaque region is defined about the centre point, and a second opaque portion is defined adjacent to the outer edge. Each point located in the first opaque portion 34 has a distance from the centre point which is smaller than rᵢₙ. Each point in the second opaque portion 35 has a distance from the centre point 32 which is larger than r_{out.} As is shown in Fig. 7, the first opaque portion 34 can have a circular shape around the centre point 32. Nevertheless, as is to be understood, the first opaque portion can as well have a shape which deviates from a circular shape. In particular, the first opaque portion can have an elliptical shape.

The illumination distribution 6 further comprises a light transmittant portion 36, which is located between the first and the second opaque portions 34, 35. The light transmittant portion 36 is a portion comprising regions having a high light intensity. For example, the transmittant portion 36 can be entirely illuminated or it may comprise a predetermined number of, for example, four illumination poles 31a, 31b, 31c and 31d. Nevertheless, as is clearly to be understood any other number of poles can be used. For example, 6 or 8 poles can be used as well. The polarization device is adapted to provide a locally varying polarization direction of the light. For example, as is indicated by the arrows in the poles 31a to 31d, the polarization direction in each of the poles is parallel to a direction connecting the centre point of the poles with the centre point 32 of the illumination distribution 6. For example, as is shown in Fig. 7, the polarization direction of the poles 31a, 31c is along the y-direction, whereas the polarization direction of the poles 31b, 31d is along the x-direction.

Likewise, the illumination distribution 6 shown in Fig. 7 could as well comprise 8 poles, wherein the polarization direction of light transmitted by the pole which is disposed between the poles 31a, 31b is rotated by 45° with respect to the y-direction and the light transmitted by the pole which is disposed between the poles 31b, 31c is rotated by 45° with respect to the x-direction. Alternatively, the illumination distribution 6 may comprise 8 poles, wherein the polarization direction of light transmitted by the pole which is disposed between the poles 31a, 31b is parallel to the y- or x-direction.

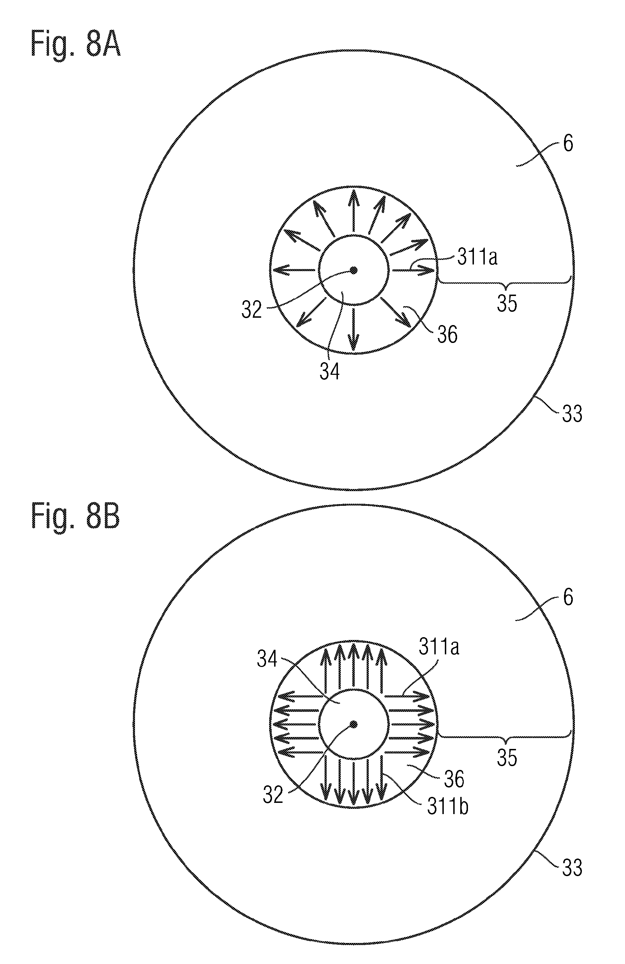

Fig. 8 illustrates a second embodiment of the present invention, wherein the light transmittant portion 36 of the illumination distribution 6 has an annular shape. As can be seen, the polarization direction of the light transmittant portion 36 can have a radial direction, i.e., the polarization direction at each point of the annular ring around the centre point 32 has a direction parallel to a direction of this point connected with the centre point 32. This distribution of the polarization directions can be simplified, as is shown in Fig. 8B. For example, in a specific range of angles between the outer edge 33 of the illumination distribution 6 and the centre point 32 the polarization direction is along the y-direction, whereas in another angular range between the outer edge 33 and the centre point 32 with respect to the x-direction the polarization direction is along the x-direction. The angular ranges for the polarization direction along the y-direction and the x-direction can be arbitrarily chosen in dependence from the system requirements.

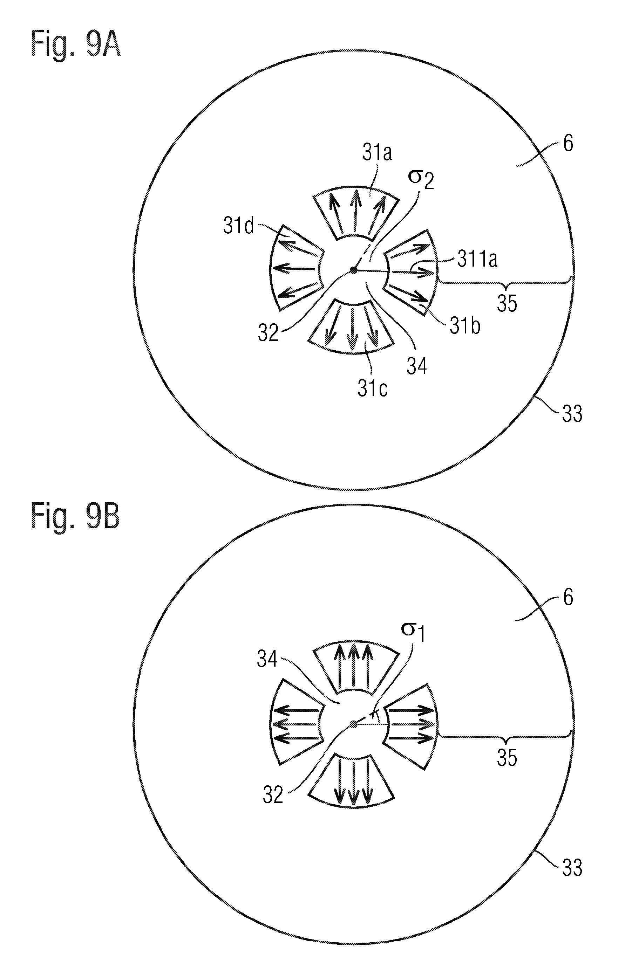

According to a further embodiment of the present invention, as is shown in Figs. 9A and 9B, the light transmittant portion 36 of the illumination distribution 6 comprises segments of a ring. In particular, the four illumination poles 31a, 31b, 31c, and 31d are not circular or elliptical but have the shape of a segment of a ring. As is shown in Fig. 9A, the polarization direction of each of the poles can have a radial direction, i.e., the polarization direction at each point of a pole has a direction parallel to a direction of this point connected with the centre point 32. This distribution of the polarization directions can be simplified, as is shown in Fig. 9B. For example, in a similar manner as in Fig. 7, the poles 31a, 31c can have a polarization direction which is parallel to the y-direction, whereas the poles 31b, 31d have a polarization direction which is parallel to the x-direction. The angles σ₁ and σ₂ can be arbitrarily chosen in accordance with the system requirements.

The locally varying polarization direction of the incident light beam can be accomplished in different manners. For example, as is indicated in Fig. 6, the polarization device may comprise a polarizer 231 for generating linearly polarized light 133. As is clearly to be understood, the polarizer 231 can be formed integrally with the light source 21, although it is illustrated as a distinct device in the shown drawing. The polarization device 23 further comprises a prism system 232. The prism system 232 is adapted to divide the linearly polarized light beam 133 into one or more light beams which are locally separated from each other. The polarization device 23 may further comprise two polarization rotating elements 233a, 233b, which may rotate the polarization direction of the incident light beams by 90°. In a similar manner, further prisms may be provided so as to obtain more divided light beams. In addition, the polarization direction can be rotated by any desired angle by providing a suitable polarization rotating elements 233a, 233b. As a further alternative, the polarization device 23 can be formed integrally with the aperture element 3, for example, as a so-called wire grid polarizer, comprising a grid in a predetermined'direction. The orientation of the wire grid polarizer is selected so that the polarization direction is achieved for the transmittant portion of the aperture element 3 as has been described above.

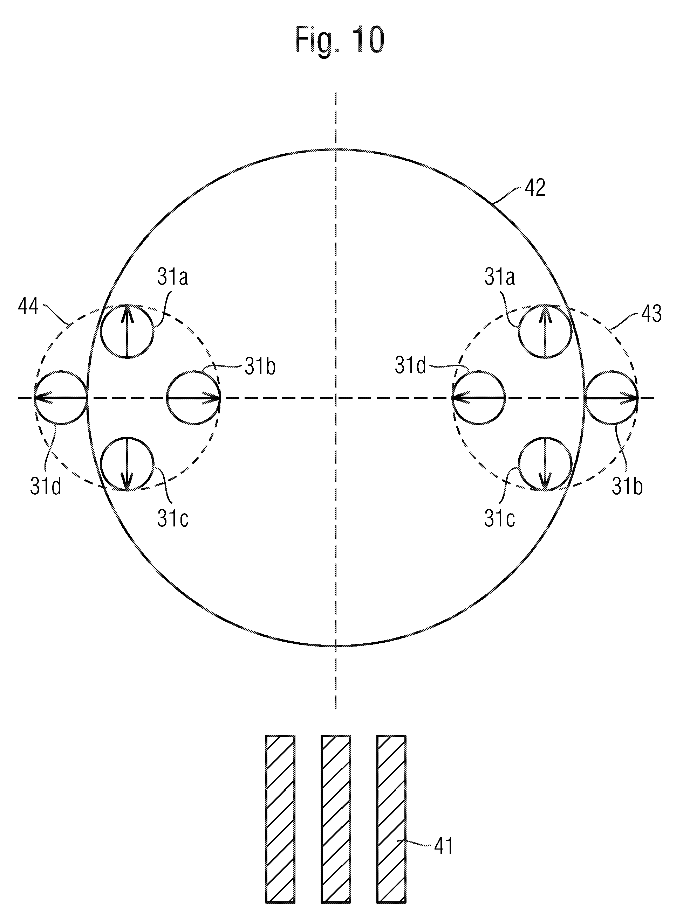

The upper portion of Fig. 10 shows the positions of the +1^{st} and -1^{st} diffracted beams in the entrance pupil 111 of the projection system 11 when using the illumination distribution shown in Fig. 7 and the pattern 41 on the reticle 4 as indicated in the lower portion of Fig. 10. In particular, Fig. 10 illustrates the positions of the poles 31a, b, c, d when being diffracted by the pattern 41. According to the present invention, a special effect is obtained if the geometrical dimensions of the device 3 for generating an illumination distribution are determined in dependence from the pitch of the pattern 41 as well as the numerical aperture (NA) of the projection system 11 for imaging the pattern onto the substrate 5. As can be seen in Fig. 10, the size of the light transmittant portion of the illumination distribution 6 is selected, so that the pole 31b is cut off the +1^{st} diffraction order and the pole 31d is cut off the -1^{st} diffraction order. As a consequence, when imaging the pattern 41 from the photo mask onto the substrate, the TM polarized radiation is decreased, resulting in a decreased amount of interference. Since the poles 31a, 31c are maintained within the entrance pupil 111, these portions will interfere with each other, resulting in an increased contrast.

In Fig. 10, the position of the + 1^{st} and - 1^{st} diffraction order depends on the pattern size dx of the pattern to be transferred. Accordingly, the smaller the pattern the smaller the value of r_{in·}

For imaging a horizontal pattern 41, which is rotated by 90° with respect to the pattern shown in Fig. 10, the same applies. In more detail, if the diffraction grating is rotated by 90°, the + 1^{st} and -1^{st} diffraction orders are located above and below the centre point shown in Fig. 10. In this case, the pole 31a is cut off the +1^{st} diffraction order whereas the pole 31c is cut off the -1^{st} diffraction order. In any case, the rim of the pupil is such that one pole including light having a polarization direction which will cause destructive interference with respect to the pattern to the image, is cut off from the entrance pupil 11 of the projection system 11. Differently stated, the diffracted beam of the +1^{st} order due to illumination with pole 31b is not captured by the pupil. Likewise, the diffracted beam of the -1^{st} order due to illumination with pole 31d is not captured by the pupil. As a consequence, the contrast of the image is remarkably increased. Hence the image quality is improved.

For imaging a pattern comprising a horizontal lines/spaces pattern as well as a vertical lines/spaces pattern, the + 1^{st} and - 1^{st} diffraction orders are disposed on the x-axis as well as on the y-axis of the system. If, in addition, the vertical pattern size dx is different from the horizontal pattern size dy, the poles on the x-axis have a size which is different from the size of the poles on the y-axis. In other words, in this case, the first and the second poles have a diameter which is different from the diameter of the third and fourth poles.

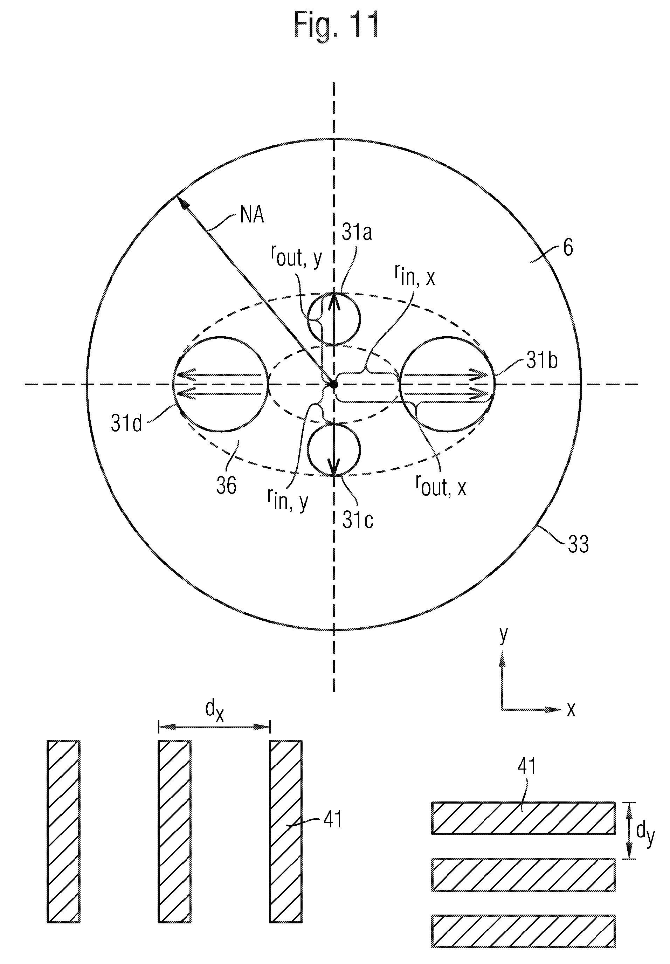

Fig. 11 shows an exemplary illumination distribution in a case in which a first pattern extending in the x-direction, having a pattern size dx, and a second pattern extending in the y-direction, the second pattern having pattern size dy are to be images. As is shown in the lower portion of Fig. 11, the pattern size dy of the pattern extending in the y-direction is smaller than the pattern size dx of the pattern extending in the x-direction. In this embodiment, the light transmittant portion 36 has an annular elliptical shape, wherein the outer radius r_{out,x} which is measured in the x-direction is larger than the outer radius r_{out,y} which is measured in the y-direction. Moreover, the inner radius r_{in,x} which is measured in the x-direction is larger than the inner radius r_{in,y} which is measured in the y-direction. As is clearly to be understood, in this case the light transmittant portion 36 may comprise illumination poles having an arbitrary shape. In particular, the poles may have a circular or an elliptical shape, or they may form segments of a ring. Alternatively, the light transmittant portion 36 may have an annular shape.

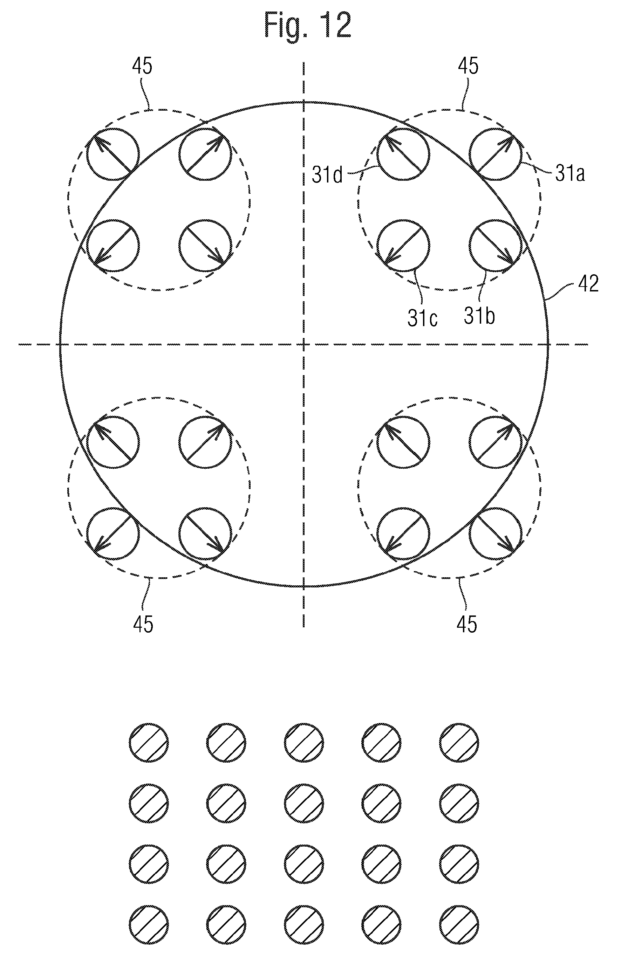

The photolithography apparatus is not only restricted to a lines/spaces pattern. It can be similarly applied to any other kind of patterns. For example, if a contact hole pattern is to be transferred, a similar illumination scheme can be used. Fig. 12 shows the ±1^{st} diffraction orders in this case. As is shown in Fig. 12, in this case, the diffracted beams due to an illumination distribution 6 which is shown in Fig. 7 are disposed on the diagonals of the system. In this case again the dimensions of the illumination distribution are selected so that one pole of the diffraction image will be removed from the pupil 111. In the case of a contact hole pattern as is illustrated in the lower portion of Fig. 12, light transmitted by the outmost poles of the illumination distribution, the light having a polarization direction which is rotated by 45° with respect to the X- or Y-direction would be destructive. Accordingly, the device for generating an illumination distribution which forms part of the illumination system of the present invention can be used in this case as well. As a consequence, the light being transmitted by the outmost poles is cut off the pupil of the projection system 11 so that finally the pattern having an improved contrast is transferred onto the wafer.

### List of references

- 1: photolithography apparatus
- 11: optical projection system
- 111: entrance pupil
- 12: interference pattern
- 13: light
- 131: first diffracted light beam
- 132: second diffracted light beam
- 133: linearly polarized light
- 14: polarization direction
- 141: first polarization direction
- 142: second polarization direction
- 20: illumination system
- 21: illumination source
- 22: condensor lens
- 23: polarization device
- 231: polarizer
- 232: prism system
- 233a, b: rotator
- 24: on-axis beam
- 25: off-axis beam
- 3: aperture element
- 30a, b, c, d: poles
- 311a: polarization direction
- 311b, c, d: polarization direction
- 31a, b, c, d: poles
- 301a, b, c, d: polarization direction
- 32: center point
- 33: outer edge
- 34: first opaque portion
- 35: second opaque portion
- 36: radiation transmittant portion
- 37: transparent portion
- 38: opaque portion
- 4: reticle
- 41: pattern
- 42: rim of the pupil
- 43: +1^{st} diffraction order, vertical
- 44: -1^{st} diffraction order, vertical
- 45: ±1^{st} diffraction order, dot-like
- 5: semiconductor wafer
- 51: wafer stage
- 6: illumination distribution

## Claims

1. An illumination system (20), the illumination system (20) being suitable for use in a photolithography apparatus (1), the illumination system (20) comprising:
- an illumination source (21) emitting electromagnetic radiation;
- a polarization device (23);
- a device (3) for generating an illumination distribution (6), the illumination distribution (6) generated by the device (3) having a center point (32) and an outer edge (33), the illumination distribution (6) comprising a first opaque portion (34) which is defined about the center point (32), each point of the first opaque portion (34) having a distance from the center point (32) smaller than rᵢₙ, a second opaque portion (35) which is defined adjacent to the outer edge (33), the second opaque portion (35) having a distance from the center point (32) which is larger than rₒᵤₜ, and a radiation transmittant portion (36) which is disposed between the first and the second opaque portions (34, 35),
wherein the polarization device (23) is disposed between the illumination source (21) and the device (3) for generating an illumination distribution, the polarization device (23) being adapted to generate linearly polarized electromagnetic radiation having a locally varying polarization direction (311a,b,c,d), so that at least a first and a second polarization directions (311a,b) are generated, the first polarization direction (311a) being different from the second polarization direction (311b) and the polarization direction at at least two different points of the radiation transmittant portion of the illumination distribution is parallel to a line connecting this point and the center point (32) of the illumination distribution.

2. The illumination system according to claim 1, wherein the radiation transmittant portion (36) comprises a first, a second, a third and a fourth pole (31a,b,c,d), wherein the first and the second poles (31a,c) are arranged along a first direction, and the third and fourth poles (31b,d) are arranged along a second direction, the second direction being perpendicular to the first direction, wherein the intensity of transmitted radiation in each of the poles is larger than in another part of the radiation transmittant portion (36), and wherein the polarization direction of the electromagnetic radiation being transmitted by the first and second poles (31a,c) is parallel to the first direction, and the polarization direction of the electromagnetic radiation being transmitted by the third and fourth poles (31b,d) is parallel to the second direction.

3. The illumination system according to claim 2, wherein each of the poles has a circular shape.

4. The illumination system according to claim 2, wherein at least one of the poles has an elliptical shape.

5. The illumination system according to claim 2, wherein at least one of the poles has the shape of a segment of a ring.

6. The illumination system according to claim 3, wherein the diameter of each of the first, second, third and fourth poles is equal to the difference between rₒᵤₜ and r_{in·}

7. The illumination system of any of claims 1 to 6, wherein the radius rᵢₙ is constant.

8. The illumination system of any of claims 1 to 7, wherein the radius rₒᵤₜ is constant.

9. The illumination system of any of claims 1 to 8, wherein the radius r_{in,y} which is measured in a first direction, is different from the radius r_{in,x} which is measured in a second direction.

10. The illumination system of any of claims 1 to 7 and 9,
wherein the radius r_{out,y} which is measured in a first direction, is different from the radius r_{out,x} which is measured in a second direction.

11. The illumination system according to claim 1, wherein the radiation transmittant portion has an annular shape, the transmitted intensity of electromagnetic radiation being constant within the radiation transmittant portion.

12. A photolithography apparatus (1) comprising:
a substrate (5) to be patterned;
a reticle (4), the reticle (4) having a plurality of patterns (41) which are to be transferred onto the substrate (5), the reticle (4) comprising at least one pattern extending in a first direction and having a pattern size dy;
an illumination system (20) as defined in claim 1 or 11; and
an optical projection system (11) for projecting an image of the reticle (4) onto the substrate (5), the optical projection system (11) having a Numerical Aperture (NA).

13. A photolithography apparatus (1) comprising:
a substrate (5) to be patterned;
a reticle (4), the reticle (4) having a plurality of patterns (41) which are to be transferred onto the substrate (5), the reticle (4) comprising at least one pattern (41) extending in a first direction and having a pattern size dy;
an illumination system (20) as defined in any of claims 2 to 10; and
an optical projection system (11) for projecting an image of the reticle (4) onto the substrate (5), the optical projection system (11) having a Numerical Aperture (NA).

14. The photolithography apparatus (1) according to claim 12, wherein the radius rₒᵤₜ of the second opaque portion (35) is determined in dependence from the pattern size dy of the reticle (4) and the Numerical Aperture (NA) of the optical projection system (11) so that for the ± 1^{st} diffraction order part of the light due to illumination with the radiation transmittant portion (36) lies outside the Numerical Aperture of the optical projection system (11).

15. The photolithography apparatus (1) according to claim 13, wherein the radius rₒᵤₜ of the second opaque portion (35) is determined in dependence from the pattern size dy of the reticle (4) and the Numerical Aperture (NA) of the optical projection system (11) so that for the ± 1^{st} diffraction order part of the light due to illumination with the radiation transmittant portion (36) lies outside the Numerical Aperture of the optical projection system (11).

16. The photolithography apparatus (1) according to claim 15, wherein the radius rₒᵤₜ of the second opaque portion (35) is determined in dependence from the pattern size dy of the reticle (4) and the Numerical Aperture (NA) of the optical projection system (11) so that for the + 1^{st} diffraction order the light due to illumination with the first pole (31a) lies outside the Numerical Aperture of the optical projection system (11) and for the -1^{st} diffraction order the light due to illumination with the second pole (31c) lies outside the Numerical Aperture of the optical projection system (11).

17. The photolithography apparatus (1) according to claim 15, wherein the radius rₒᵤₜ of the second opaque portion (35) is determined in dependence from the pattern size dy of the reticle (4) and the Numerical Aperture (NA) of the optical projection system (11) so that for the + 1^{st} diffraction order the light due to illumination with the third pole (31b) lies outside the Numerical Aperture of the optical projection system (11) and for the -1^{st} diffraction order the light due to illumination with the fourth pole (31d) lies outside the Numerical Aperture of the optical projection system (11).

18. The photolithography apparatus (1) according to claim 12, wherein the reticle (4) additionally comprises a pattern (41) extending in a second direction and having a pattern size dx; wherein the radius r_{out,y} of the second opaque portion (35), the radius r_{out,y} extending in the first direction, is determined in dependence from the pattern size dy of the reticle (4) and the Numerical Aperture (NA) of the optical projection system (11), and the radius r_{out,x} of the second opaque portion (35), the radius r_{out,x} extending in the second direction, is determined in dependence from the pattern size dx of the reticle (4) and the Numerical Aperture (NA) of the optical projection system (11) so that for the ± 1^{st} diffraction order part of the light due to illumination with the radiation transmittant portion (36) lies outside the Numerical Aperture of the optical projection system (11).

19. The photolithography apparatus (1) according to claim 13, wherein the reticle (4) additionally comprises a pattern (41) extending in a second direction and having a pattern size dx; wherein the radius r_{out,y} of the second opaque portion (35), the radius r_{out,y} extending in the first direction, is determined in dependence from the pattern size dy of the reticle (4) and the Numerical Aperture (NA) of the optical projection system (11), and the radius r_{out,x} of the second opaque portion (35), the radius r_{out,x} extending in the second direction, is determined in dependence from the pattern size dx of the reticle (4) and the Numerical Aperture (NA) of the optical projection system (11) so that for the ± 1^{st} diffraction order part of the light due to illumination with the radiation transmittant portion (36) lies outside the Numerical Aperture of the optical projection system (11).
